# EUROPÄISCHE PATENTSCHRIFT

(11) **EP 2 917 944 B1**
(45) Veröffentlichungstag und Bekanntmachung des Hinweises auf die Patenterteilung: **07.12.2016**
(21) Anmeldenummer: 13734677.1
(22) Anmeldetag: 11.06.2013
(51) Int. Cl.: H01L 35/32, H01L 35/34, H01L 35/08, H01L 27/16

(54) **THERMOELEKTRISCHES ELEMENT SOWIE VERFAHREN ZU DESSEN HERSTELLUNG**
THERMOELECTRIC ELEMENT AND METHOD FOR THE PRODUCTION THEREOF
ÉLÉMENT THERMOÉLECTRIQUE ET PROCÉDÉ DE FABRICATION CORRESPONDANT

(30) Priorität: 24.01.2013 DE 102013100691
(43) Veröffentlichungstag der Anmeldung: 16.09.2015
(73) Patentinhaber: O-Flexx Technologies GmbH, 47059 Duisburg (DE)
(72) Erfinder: IOSAD, Nikolay, 65232 Taunusstein (DE)
(74) Vertreter: Kohlmann, Kai
(86) Internationale Anmeldenummer: PCT/EP2013/061989
(87) Internationale Veröffentlichungsnummer: WO 2014/114366

(56) Entgegenhaltungen:
- EP-A2- 1 976 034
- WO-A2-2004/013900
- WO-A2-2010/142880
- JP-A- 2008 205 129
- JP-A- 2011 192 923

## Beschreibung

Die Erfindung betrifft ein thermoelektrisches Dünnschichtelement mit einer ersten und einer zweiten thermoelektrischen Schicht, wobei die Schichten unter Ausbildung eines pn-Übergangs ausgebildet sind. Außerdem betrifft die Erfindung ein Verfahren zur Herstellung eines derartigen thermoelektrischen Elementes sowie einen thermoelektrischen Generator.

Ein gattungsgemäßes thermoelektrisches Element ist aus der EP 1 287 566 B1 bekannt. Bei diesem thermoelektrischen Element wird gegenüber herkömmlichen thermoelektrischen Elementen ein höherer Wirkungsgrad erreicht, in dem ein pn-Übergang im Wesentlichen über die gesamte Erstreckung der n- und p-Schicht ausgebildet wird, wobei ein Temperaturgradient entlang der pn-Übergangsgrenzfläche angelegt wird. Hierdurch entsteht ein Temperaturunterschied entlang dieses länglich ausgebildeten pn-Übergangs zwischen zwei Enden des pn-Schichtpaketes, welcher dazu führt, dass der Wirkungsgrad des thermoelektrischen Elementes deutlich höher als bei herkömmlichen thermoelektrischen Elementen ist. Das gattungsgemäße thermoelektrische Element wird selektiv an der n- und p-Schicht kontaktiert. Dies kann entweder durch Einlegieren der Kontakte und den damit verbundenen pn-Übergängen oder durch eine direkte Kontaktierung der n- und p-Schicht erfolgen. Um mehrere gattungsgemäße thermoelektrische Elemente zu einem Modul zusammenzuschalten, werden diese durch über Kreuz geführte Leitungen in Serie geschaltet. Thermisch sind die einzelnen thermoelektrischen Elemente des Moduls parallel geschaltet.

JP2011-192923 beschreibt ein thermoelektrisches Element.

Ausgehend von diesem Stand der Technik liegt der Erfindung die Aufgabe zu Grunde, ein gattungsgemäßes thermoelektrisches Element vorzuschlagen, das ohne Verkabelung für eine Reihenschaltung in einem thermoelektrischen Generator geeignet ist. Des Weiteren soll ein Verfahren zur Herstellung eines derartigen thermoelektrischen Elementes angegeben werden.

Die Lösung dieser Aufgabe basiert auf dem Gedanken, das thermoelektrische Dünnschichtelement auf der kalten Seite mit zwei Kontaktflächen und auf der heißen Seite mit einer Kontaktfläche zu verbinden. Des Weiteren basiert die Erfindung auf dem Gedanken, ein kostengünstiges Verfahren zur Herstellung der drei Kontaktflächen zur Verfügung zu stellen.

Im Einzelnen wird die Aufgabe bei einem thermoelektrischen Element der eingangs erwähnten Art dadurch gelöst, dass ein Substrat eine erste und zweite Kontaktfläche auf einer kalten Seite und eine dritte Kontaktfläche auf einer heißen Seite des Substrats aufweist, zwischen den Kontaktflächen auf der kalten und heißen Seite ein Temperaturgradient anlegbar ist, die erste thermoelektrische Schicht des thermoelektrischen Elementes auf dem Substrat angeordnet ist und eine zweite Kontaktfläche mit einer dritten Kontaktfläche verbindet und die zweite thermoelektrische Schicht des thermoelektrischen Elementes unter Ausbildung des pn-Übergangs auf der ersten thermoelektrischen Schicht angeordnet und mit der ersten Kontaktfläche verbunden ist.

Das Schichtpaket aus einer p- und einer n-Schicht wird durch die erste und zweite Kontaktfläche auf der kalten Seite selektiv kontaktiert, indem die erste thermoelektrische Schicht mit einem Kontaktabschnitt auf der zweiten Kontaktfläche des Substrats angeordnet ist. Die selektive Kontaktierung der zweiten thermoelektrischen Schicht erfolgt mittels eines Kontaktabschnitts der zweiten thermoelektrischen Schicht, der auf der ersten Kontaktfläche des Substrats angeordnet ist. Der Kontaktabschnitt der zweiten thermoelektrischen Schicht ragt über den pn-Übergang zwischen erster und zweiter thermoelektrischer Schicht hinaus.

Um den Temperaturgradienten in Richtung der Grenzschicht zwischen der n- und der p-Schicht wirksam werden zu lassen, ist zwischen den Kontaktflächen auf der kalten und heißen Seite ein Temperaturgradient anlegbar. Hierzu ist es erforderlich, dass die Kontaktabschnitte der ersten und zweiten thermoelektrischen Schichten die jeweiligen Kontaktflächen lediglich in Teilbereichen überlappen. Über die verbleibenden Bereiche der Kontaktflächen wird eine gute thermische Anbindung an eine Wärmequelle oder Wärmesenke sichergestellt. Über die ersten und zweiten Kontaktflächen auf der kalten Seite erfolgt zugleich die selektive elektrische Kontaktierung der thermoelektrischen Schichten.

Wenn die erste thermoelektrische Schicht aus einem n-leitenden thermoelektrischen Halbleitermaterial besteht, besteht die zweite thermoelektrische Schicht aus einem p-leitenden thermoelektrischen Material. Wenn die erste thermoelektrische Schicht aus einem p-leitenden thermoelektrischen Material besteht, besteht die zweite thermoelektrische Schicht aus einem n-leitenden thermoelektrischen Material. Der pn-Übergang wird vorzugsweise entlang der gesamten vorzugsweise längsten Ausdehnung der n-Schicht und der p-Schicht und damit im Wesentlichen entlang von deren gesamter Grenzschicht ausgebildet.

Als thermoelektrische Materialien kommen insbesondere Halbleitermaterialien, wie Bi₂Te₃, PbTe, SiGe, BiSb oder FeSi₂ in Betracht.

Das Substrat besteht aus einem elektrisch isolierenden Material mit einer gegenüber den Kontaktflächen deutlich geringeren Wärmeleitfähigkeit. Das Substratmaterial kann starr oder flexibel sein. Als Substratmaterialien kommen beispielsweise Kapton, Kevlar sowie Leiterplattenmaterialien, wie EP2, 85N, 35N oder Kompositmaterialien in Betracht.

Die Kontaktflächen müssen eine hohe elektrische und eine hohe Wärmeleitfähigkeit aufweisen, um eine gute thermische Anbindung an die Wärmequelle und -senke mittels Klammern, Kleben oder anderer Form oder stoffflüssiger Verbindungsmethoden zu erreichen. Die hohe elektrische Leitfähigkeit wird einerseits für die selektive Kontaktierung der Schichtmaterialien und andererseits zum Abgreifen der von dem thermoelektrischen Element bzw. Generator erzeugten Spannung benötigt. Als Materialien für die Kontaktflächen kommen Metalle mit einer hohen thermischen und elektrischen Leitfähigkeit, insbesondere Kupfer oder Kupferlegierungen in Betracht. Die Kontaktbereiche können zusätzlich mit Nickel als Diffusionsbarierre beschichtet werden.

Um die sich von dem pn-Übergang erstreckenden Kontaktabschnitte der ersten und zweiten Schicht im Interesse eines hohen Wirkungsgrades möglichst kurz zu halten, ist die dritte Kontaktfläche vorzugsweise versetzt zu der ersten und zweiten Kontaktfläche angeordnet. Der Versatz wird vorzugsweise derart gewählt, dass die Verlängerung des Spaltes zwischen der ersten und zweiten Kontaktfläche die dritte Kontaktfläche schneidet.

In einem thermoelektrischen Generator mit den Merkmalen des Anspruchs 6 lässt sich die Ausgangsspannung der von den thermoelektrischen Elementen erzeugten Spannung erhöhen. Im Interesse einer automatisierten Herstellung eines derartigen Generators sind sämtliche thermoelektrischen Elemente vorzugsweise auf nur einem Substrat angeordnet, wobei die ersten und zweiten Kontaktflächen sämtlicher thermoelektrischer Elemente in einer Reihe auf der heißen Seite und die dritten Kontaktflächen sämtlicher thermoelektrischer Elemente in einer Reihe auf der kalten Seite des Substrats angeordnet sind. Das Substrat weist vorzugsweise eine rechteckige längliche Form auf, wobei eine Längskante die heiße Seite und die gegenüberliegende Längskante die kalte Seite bildet. Parallel zu den Längskanten verlaufen die Reihen der Kontaktflächen auf der heißen und kalten Seite. Die ersten und zweiten Kontaktflächen sind vorzugsweise wesentlich größer als die auf den Kontaktflächen aufliegenden Kontaktabschnitte der ersten und zweiten thermoelektrischen Schichten. In Folge dieser Größenverhältnisse ist es erfindungsgemäß möglich, dass die zweite Kontaktfläche eines thermoelektrischen Elementes zugleich die erste Kontaktfläche für ein benachbartes thermoelektrisches Element des Generators bildet. Hierdurch wird auf besonders einfache und kostengünstige Weise die elektrische Serienschaltung zwischen benachbarten thermoelektrischen Elementen eines thermoelektrischen Generators ausgeführt.

Ein bevorzugtes Verfahren zur Herstellung eines thermoelektrischen Elementes bzw. eines daraus hergestellten Generators ergibt sich aus den Merkmalen des Anspruchs 9. Das Aufbringen der thermoelektrischen Schichten kann mit unterschiedlichen Depositionsverfahren, vorzugsweise jedoch im Wege eines Druckprozesses erfolgen. Als Druckverfahren für das thermoelektrische Material kommt insbesondere ein Tintenstrahl-, Off-Set- oder Tiefdruck in Betracht. Die verwendete Tinte kann Partikel aus Wismuthtellurid (Bi₂Te₃), Antimontellurid (Sb₂Te₃) und/oder Wismuthselenid (Bi₂Se₃), dotiertem Silizium-Germanium (SiGe), dotiertem Silizium (Si) oder anderen thermoelektrischen Materialien enthalten.

Nach dem Aufbringen einer Schicht des thermoelektrischen Materials wird dieses vorzugsweise gesintert und/oder ausgeheilt, um die Eigenschaften der aufgebrachten Schichten zu verändern. Insbesondere werden durch das Ausheilen Kristallschäden beseitigt. Sofern zusätzlich bei der Temperaturbehandlung ein Druck ausgeübt wird, spricht man von einer Sinterung.

Nachfolgend wird das Verfahren zur Herstellung eines erfindungsgemäßen thermoelektrischen Elementes bzw. eines Moduls anhand der Figuren 1 - 3 näher erläutert. Es zeigen:
- **Figur 1**: ein schematisches Layout nach dem Aufbringen der ersten thermoelektrischen Schicht,
- **Figur 2**: ein schematisches Layout nach dem Aufbringen der zweiten thermoelektrischen Schicht sowie
- **Figur 3**: eine Aufsicht auf ein fertig gestelltes thermoelektrisches Element einschließlich der Schnitte A-A und B-B.

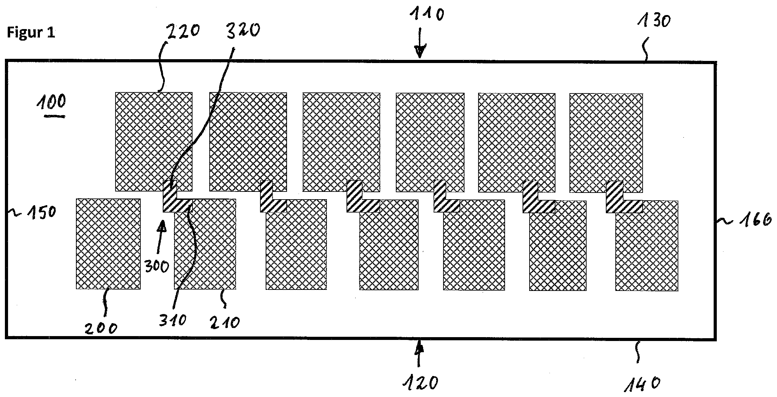

Figur 1 zeigt ein Substrat (100) mit einer heißen Seite (110) und einer kalten Seite (120). Das Substrat (100) weist eine längliche rechteckige Form auf, die durch die Längsränder (130, 140) sowie die Querränder (150, 160) begrenzt wird. Zur Herstellung des thermoelektrischen Elementes wird das Substrat mit mindestens einer ersten Kontaktfläche (200), einer zweiten Kontaktfläche (210) auf der kalten Seite (120) und mindestens einer dritten Kontaktfläche (220) auf der heißen Seite (110) versehen. Die Kontaktflächen (200, 210, 220) bestehen beispielsweise aus Kupfer.

Auf das derart bereitgestellte Substrat (100) wird zunächst die erste thermoelektrische Schicht aus p-dotiertem Halbleitermaterial, nachfolgend als p-Schicht (300) bezeichnet, derart aufgebracht, dass die p-Schicht (300) die zweite Kontaktfläche (210) mit der dritten Kontaktfläche (220) verbindet. Der mit der zweiten Kontaktfläche (210) überlappende Kontaktabschnitt (310) dient der selektiven Kontaktierung des thermoelektrischen Elementes sowie der Auskopplung der Wärme. Der mit der dritten Kontaktfläche (220) überlappende Kontaktabschnitt (320) dient der Einkopplung der Wärme von einer Wärmequelle, die an die dritten Kontaktflächen (220) angebunden ist.

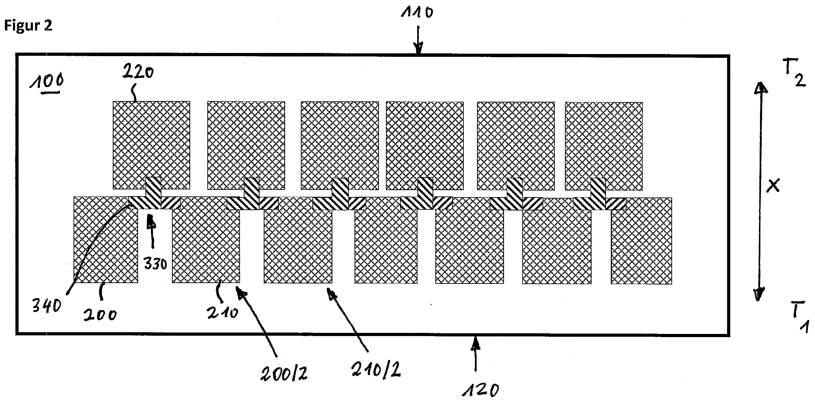

In einem nächsten in Figur 2 veranschaulichten Verfahrensschritt, wird die zweite thermoelektrische Schicht aus thermoelektrisch leitendem, n-dotiertem Material, nachfolgend kurz als n-Schicht (330) bezeichnet, unter Ausbildung des pn-Übergangs auf der p-Schicht (300) aufgebracht und zugleich mit der ersten Kontaktfläche (200) verbunden. Der mit der ersten Kontaktfläche (200) überlappende Kontaktabschnitt (340) dient der Auskopplung der Wärme. Die n-Schicht (330) und die p-Schicht (300) bilden in Richtung X (vgl. Figur 2) einen pn-Übergang aus, wobei die p-Schicht (300) mit ihrem Kontaktabschnitt (310) elektrisch durch die zweite Kontaktfläche (210) selektiv kontaktiert und die n-Schicht (330) mit ihrem Kontaktabschnitt (340) über die erste Kontaktfläche (200) elektrisch selektiv kontaktiert ist.

Der Temperaturgradient in der Grenzschicht zwischen der n- und p-Schicht (300, 330) verläuft parallel zu der in Figur 2 dargestellten X-Richtung von der heißen Seite (110) zur kalten Seite (120). Durch den Temperaturgradienten parallel zur Grenzschicht zwischen der n- und p-Schicht kommt es zu einer Generation von Elektron-Lochpaaren im Bereich der hohen Temperatur und zu einer Rekombination dieser Paare im Bereich der niedrigeren Temperaturen mit dazugehörigen Ausgleichsströmen auf der kalten Seite (120). Da sich die Potenzial-Modulation zwischen n- und p-Schicht im Vergleich zum thermischen Gleichgewicht ändert, kann eine Spannung zwischen der n- und p-Schicht über die ersten und zweiten Kontaktflächen (200, 210) abgegriffen werden. Fertigungstechnisch ist es vorteilhaft, dass die dritte Kontaktfläche (220) versetzt zu der ersten und zweiten Kontaktfläche (210, 220) angeordnet ist, wie dies aus den Figuren 1 und 2 erkennbar ist. Der Spalt zwischen der ersten und zweiten Kontaktfläche (200, 210) ist breiter als die Breite des pn-Übergangs zwischen der p-Schicht (300) und der n-Schicht (330), so dass sich der pn-Übergang von der versetzten dritten Kontaktfläche (220) in den Spalt zwischen der ersten und zweiten Kontaktfläche (200, 210) erstrecken kann, ohne mit den Kontaktflächen (200, 210) zu überlappen. Rechtwinklig von dem pn-Übergang (300, 330) erstrecken sich die Kontaktabschnitte (310, 340) in Richtung der ersten und zweiten Kontaktflächen (200, 210).

Um mehrere thermoelektrische Elemente zu einem Modul zu verbinden, sind diese vorzugsweise auf einem einzigen Substrat (100) angeordnet, wobei die ersten und zweiten Kontaktflächen (200, 210) sämtlicher thermoelektrischer Elemente in einer Reihe auf der heißen Seite (110) und die dritten Kontaktflächen (220) sämtlicher thermoelektrischer Elemente in einer Reihe auf der kalten Seite (120) angeordnet sind. Die Reihenschaltung mehrerer thermoelektrischer Elemente eines thermoelektrischen Generators lässt sich besonders einfach dadurch bewerkstelligen, dass die zweite Kontaktfläche (210) eines ersten thermoelektrischen Elementes zugleich die erste Kontaktfläche (200) für das benachbarte thermoelektrische Element bildet, wie dies in der Aufsicht nach Figur 2 erkennbar ist. Ausgehend von dem in der Aufsicht links dargestellten ersten thermoelektrischen Element teilt sich das zweite thermoelektrische Element die zweite Kontaktfläche (210) mit dem ersten thermoelektrischen Element, wobei die zweite Kontaktfläche (210) für das zweite thermoelektrische Element die erste Kontaktfläche (200/2) bildet.

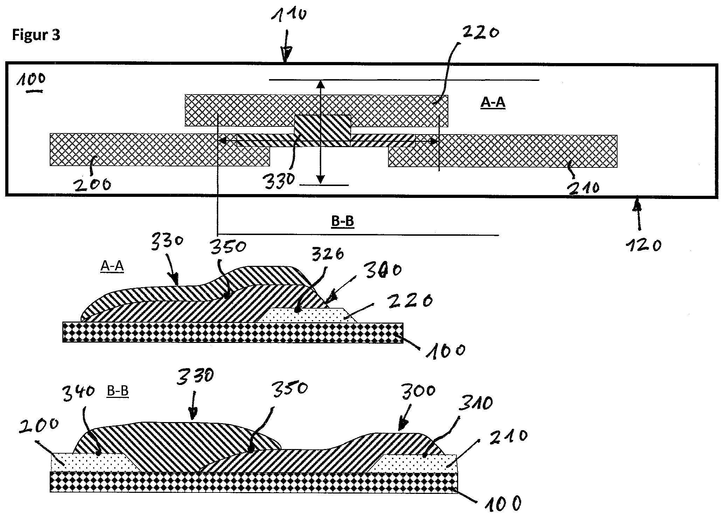

Figur 3 zeigt ein detailliertes Layout, des nach dem erfindungsgemäßen Verfahren hergestellten thermoelektrischen Elementes einschließlich der Querschnitte A-A und B-B. Die drei Kontaktflächen (200, 210, 220) auf dem Substrat (100) sind in der Aufsicht erkennbar. Die Kontaktflächen (200, 210) gehören zu der Reihe der Kontaktflächen auf der kalten Seite (120), während die dritte Kontaktfläche (220) zu der Reihe der Kontaktflächen auf der heißen Seite (110) gehört.

Im Querschnitt A-A ist erkennbar, wie der Kontaktabschnitt (320) der p-Schicht (300) die dritte Kontaktfläche (220) überlappt und sich im Übrigen in Richtung der kalten Seite (120) in dem Spalt zwischen der ersten und zweiten Kontaktfläche (200, 210) auf dem Substrat (100) erstreckt. Des Weiteren ist die n-Schicht (330) erkennbar, die unter Ausbildung des pn-Übergangs (350) auf der p-Schicht (300) aufgebracht ist.

Aus dem Schnitt B-B ist erkennbar, wie sich die von dem pn-Übergang (350) in Längsrichtung des Substrats (100) erstreckenden Kontaktabschnittes (340, 310) mit den ersten und zweiten Kontaktflächen (200, 210) überlappen. Wie aus dem Schnitt B-B erkennbar, überlappen sich die p- und n-Schicht (300, 330) ausschließlich oberhalb des Substrats (100) in dem Spalt zwischen der ersten und zweiten Kontaktfläche (200, 210).

**Bezugszeichenliste**

| **Nr.** | **Bezeichnung** |
|---|---|
| 100 | Substrat |
| 110 | heiße Seite |
| 120 | kalte Seite |
| 130 | Längsrand |
| 140 | Längsrand |
| 150 | Querrand |
| 160 | Querrand |
| | |
| 200 | erste Kontaktfläche |
| 210 | zweite Kontaktfläche |
| 220 | dritte Kontaktfläche |
| | |
| 300 | p-Schicht |
| 310 | Kontaktabschnitt |
| 320 | Kontaktabschnitt |
| 330 | n-Schicht |
| 340 | Kontaktabschnitt |
| 350 | pn-Übergang |
| | |
| | |

## Patentansprüche

1. Thermoelektrisches Element mit einer ersten themoelektrischen Schicht (300) und einer zweiten thermoelektrischen Schicht (330), wobei die Schichten (300, 330) unter Ausbildung eines pn-Übergangs (350) ausgebildet sind, wobei die erste thermoelektrische Schicht (300) aus einem n-leitenden thermoelektrischen Material besteht und die zweite thermoelektrische Schicht (330) aus einem p-leitenden thermoelektrischen Material besteht oder die erste thermoelektrische Schicht (300) aus einem p- leitenden thermoelektrischen Material besteht und die zweite thermoelektrische Schicht (330) aus einem n- leitenden thermoelektrischen Material besteht, **dadurch gekennzeichnet, dass**
- ein Substrat (100) eine erste und zweite Kontaktfläche (200, 210) auf einer kalten Seite (120) und eine dritte Kontaktfläche (220) auf einer heißen Seite (110) des Substrats (100) aufweist,
- zwischen den Kontaktflächen (200, 210, 220) auf der kalten und heißen Seite (110, 120) ein Temperaturgradient (T1, T2) anlegbar ist,
- die erste thermoelektrische Schicht (300) des thermoelektrischen Elementes auf dem Substrat (100) angeordnet ist und eine zweite Kontaktfläche (210) mit einer dritten Kontaktfläche (220) verbindet und
- die zweite thermoelektrische Schicht (330) des thermoelektrischen Elementes unter Ausbildung des pn-übergangs (350) auf der ersten thermoelektrischen Schicht (300) angeordnet und mit der ersten Kontaktfläche (200) verbunden ist und
- die erste und zweite Kontaktfläche (200,210) auf der kalten Seite das Schichtpaket aus erster und zweiter thermolektrischer Schicht (300, 330) selektiv kontaktierten, indem die erste thermoelektrische Schicht (300) mit einem Kontaktabschnitt (310) auf der zweiten Kontaktfläche (210) des Substrats (100) angeordnet ist und die zweite thermoelektrische Schicht (330) mit einem Kontaktabschnitt (340) auf der ersten Kontaktfläche (200) des Substrats (100) angeordnet ist,
- wobei der Kontaktabschnitt (340) der zweiten thermoelektrischen Schicht (330) über den pn-Übergang zwischen erster und zweiter thermoelektrischer Schicht hinausragt.

2. Thermoelektrisches Element nach Anspruch 1, **dadurch gekennzeichnet, dass** das Substrat (100) aus einem elektrisch isolierenden Material mit einer gegenüber den Kontaktflächen (200, 210, 220) geringeren Wärmeleitfähigkeit besteht.

3. Thermoelektrisches Element nach Anspruch 1 oder 2, **dadurch gekennzeichnet, dass** die Kontaktflächen (200, 210, 220) eine hohe elektrische und eine hohe Wärmeleitfähigkeit aufweisen.

4. Thermoelektrisches Element nach einem der Ansprüche 1 bis 3, **dadurch gekennzeichnet, dass** die dritte Kontaktfläche (220) versetzt zu der ersten und zweiten Kontaktfläche (210, 220) angeordnet ist.

5. Thermoelektrischer Generator umfassend mehrere thermisch parallel und elektrisch in Reihe geschaltete thermoelektrische Elemente nach einem der Ansprüche 1 bis 4.

6. Thermoelektrischer Generator nach Anspruch 5, **dadurch gekennzeichnet, dass** sämtliche thermoelektrischen Elemente auf nur einem Substrat (100) angeordnet sind, die ersten und zweiten Kontaktflächen (200, 210) sämtlicher thermoelektrischer Elemente in einer Reihe auf der kalten Seite (120) des Substrats (100) und die dritten Kontaktflächen (220) sämtlicher thermoelektrischer Elemente in einer Reihe auf der heißen Seite (110) des Substrats angeordnet sind.

7. Thermoelektrischer Generator nach Anspruch 5 oder 6, **dadurch gekennzeichnet, dass** die zweite Kontaktfläche (210) eines thermoelektrischen Elementes zugleich die erste Kontaktfläche (200) für ein benachbartes thermoelektrisches Element bildet.

8. Verfahren zur Herstellung eines thermoelektrischen Elementes gemäß Anspruch 1 mit einer ersten thermoelektrischen Schicht (300) und einer zweiten thermoelektrischen Schicht (330), wobei die Schichten (300, 330) unter Ausbildung eines pn-Übergangs (350) ausgebildet sind, wobei die erste thermcelektrische Schicht (300) aus einem n-leitenden thermoelektrischen Material besteht und die zweite thermoelektrische Schicht (330) aus einem p-leitenden thermoelektrischen Material besteht oder die erste thermoelektrische Schicht (300) aus einem p- leitenden thermoelektrischen Material besteht und die zweite thermoelektrische Schicht (330) aus einem n- leitenden thermoelektrischen Material besteht, **dadurch gekennzeichnet, dass**
- ein Substrat (100) mit mindestens einer ersten und mindestens einer zweiten Kontaktfläche (200, 210) auf einer kalten Seite (120) und mindestens einer dritten Kontaktfläche (220) auf einer heißen Seite (110) des Substrats versehen wird,
- anschließende die erste thermoelektrische Schicht (300) des thermoelektrischen Elementes derart auf dem Substrat (100) aufgebracht wird, das die erste thermoelektrische Schicht (300) die zweite Kontaktfläche (210) mit der dritten Kontaktfläche (220) verbindet und
- die zweite thermoelektrische Schicht (330) des thermielektrischen Elementes unter Ausbildung des pn-Übergangs (350) auf der ersten thermoelektrischen Schicht (300) aufgebracht und mit der ersten Kontaktfläche (200) verbunden wird.

9. Verfahren zur Herstellung eines thermoelektrischen Elementes nach Anspruch 8, **dadurch gekennzeichnet, dass** die thermoelektrischen Schichten im Wege eines Druckprozesses aufgebracht werden.

10. Verfahren zur Herstellung eines thermoelektrischen Elementes nach Anspruch 8 oder 9, **dadurch gekennzeichnet, dass** die thermoelektrischen Schichten nach dem Aufbringen jeweils gesintert und/oder ausgeheilt werden.

## Claims

1. A thermoelectric element, comprising a first thermoelectric layer (300) and a second thermoelectric layer (330) wherein the layers (300, 330) are configured to form a p-n junction (350), wherein the first thermoelectric layer (300) consists of an n-conductive thermoelectric material and the second thermoelectric layer (330) consists of a p-conductive thermoelectric material, or the first thermoelectric layer (300) consists of a p-conductive thermoelectric material and the second thermoelectric layer (330) consists of an n-conductive thermoelectric material, **characterized in that**
- a substrate (100) has a first and second contact surface (200, 210) on a cold side (120) and a third contact surface (220) on a hot side (110) of the substrate (100),
- a temperature gradient (T1, T2) can be applied between the contact surfaces (200, 210, 220) on the cold and hot side (110, 120),
- the first thermoelectric layer (300) of the thermoelectric element is disposed on the substrate (100) and connects a second contact surface (210) to a third contact surface (220),
- the second thermoelectric layer (330) of the thermoelectric element is disposed on the first thermoelectric layer (300) to form the p-n junction (350) and is connected to the first contact surface (200) and
- the first and second contact surface (200, 210) on the cold side selectively contact the layer package comprising first and second thermoelectric layer (300, 330) whereby the first thermoelectric layer (300) is disposed with a contact section (310) on the second contact surface (210) of the substrate (100) and the second thermoelectric layer (330) is disposed with a contact section (340) on the first contact surface (200) of the substrate (100),
- wherein the contact section (340) of the second thermoelectric layer (330) extends over the p-n junction between the first and second thermoelectric layer.

2. The thermoelectric element according to claim 1, **characterized in that** the substrate (100) consists of an electrically insulating material having a lower thermal conductivity compared with the contact surfaces (200, 210, 220).

3. The thermoelectric element according to claim 1 or 2, **characterized in that** the contact surfaces (200, 210, 220) have a high electrical conductivity and a high thermal conductivity.

4. The thermoelectric element according to any one of claims 1 to 3, **characterized in that** the third contact surface (220) is arranged with an offset to the first and second contact surfaces (210, 220).

5. A thermoelectric generator comprising a plurality of thermoelectric elements according to any one of claims 1 to 4 connected thermally in parallel and electrically in series.

6. The thermoelectric generator according to claim 5, **characterized in that** all the thermoelectric elements are arranged on only a single substrate (100), the first and second contact surfaces (200, 210) of all the thermoelectric elements are arranged in a row on the cold side (120) of the substrate (100) and the third contact surfaces (220) of all of the thermoelectric elements are arranged in a row on the hot side (110) of the substrate.

7. The thermoelectric generator according to claim 5 or 6, **characterized in that** the second contact surface (210) of one thermoelectric element at the same time forms the first contact surface (200) for an adjacent thermoelectric element.

8. A method for the production of a thermoelectric element according to claim 1 with a first thermoelectric layer (300) and a second thermoelectric layer (330), wherein the layers (300, 330) are configured to form a p-n junction (350), wherein the first thermoelectric layer (300) consists of an n-conductive thermoelectric material and the second thermoelectric layer (330) consists of a p-conductive thermoelectric material, or the first thermoelectric layer (300) consists of a p-conductive thermoelectric material and the second thermoelectric layer (330) consists of an n-conductive thermoelectric material, **characterized in that**
- a substrate (100) with at least one first and at least one second contact surface (200, 210) is provided on a cold side (120), and at least one third contact surface (220) on a hot side (110) of the substrate;
- then the first thermoelectric layer (300) of the thermoelectric element is applied to the substrate (100) in such a manner that the first thermoelectric layer (300) connects the second contact surface (210) to the third contact surface (220) and
- the second thermoelectric layer (330) of the thermoelectric element is applied to the first thermoelectric layer (300) to form the p-n junction (350) and is connected to the first contact surface (200).

9. The method for the production of a thermoelectric element according to claim 8, **characterized in that** the thermoelectric layers are applied using a printing process.

10. The method for the production of a thermoelectric element according to claim 8 or 9, **characterized in that** the thermoelectric layers are each sintered and/or cured after application.

## Revendications

1. Élément thermoélectrique avec une première couche (300) thermoélectrique et une deuxième couche (330) thermoélectrique, les couches (300, 330) étant conçues en formant une jonction pn (350), la première couche (300) thermoélectrique étant constituée d'une matière thermoélectrique conductrice de type n et la deuxième couche (330) thermoélectrique étant constituée d'une matière thermoélectrique conductrice de type p ou la première couche (300) thermoélectrique étant constituée d'une matière thermoélectrique conductrice de type p et la deuxième couche (330) thermoélectrique étant constituée d'une matière thermoélectrique conductrice de type n, **caractérisé en ce**
- **qu'**un substrat (100) comporte une première et une deuxième surfaces de contact (200, 210) sur un côté froid (120) et une troisième surface de contact (220) sur un côté chaud (110) du substrat (100),
- **qu'**un gradient thermique (T1, T2) est applicable entre les surfaces de contact (200, 210, 220), sur le côté froid et chaud (110, 120),
- **que** la première couche (300) thermoélectrique de l'élément thermoélectrique est placée sur le substrat (100) et relie une deuxième surface de contact (210) avec une troisième surface de contact (220) et
- **qu'**en formant la jonction pn (350), la deuxième couche (330) thermoélectrique de l'élément thermoélectrique est placée sur la première couche (300) thermoélectrique et reliée avec la première surface de contact (200) et
- **que** sur le côté froid, la première et la deuxième surfaces de contact (200, 210) contactent sélectivement le paquet de couches de la première et de la deuxième couches (300, 330) thermoélectriques, en ce que par un segment de contact (310), la première couche (300) thermoélectrique est placée sur la deuxième surface de contact (210) du substrat (100) et par un segment de contact (340), la deuxième couche (330) thermoélectrique est placée sur la première surface de contact (200) du substrat (100),
- le segment de contact (340) de la deuxième couche (330) thermoélectrique saillant par-dessus la jonction pn entre la première et la deuxième couches thermoélectriques.

2. Élément thermoélectrique selon la revendication 1, **caractérisé en ce que** le substrat (100) est constitué d'une matière isolante électrique avec une conductibilité thermique plus faible par rapport aux surfaces de contact (200, 210, 220).

3. Élément thermoélectrique selon la revendication 1 ou 2, **caractérisé en ce que** les surfaces de contact (200, 210, 220) font preuve d'une conductibilité électrique élevée et d'une conductibilité thermique élevée.

4. Élément thermoélectrique selon l'une quelconque des revendications 1 à 3, **caractérisé en ce que** la troisième surface de contact (220) est placée en étant déportée par rapport à la première et à la deuxième surfaces de contact (210, 220).

5. Générateur thermoélectrique comprenant plusieurs éléments thermoélectriques selon l'une quelconque des revendications 1 à 4, montés en parallèle du point de vue thermique et en série du point de vue électrique.

6. Générateur thermoélectrique selon la revendication 5, **caractérisé en ce que** tous les éléments thermoélectriques ne sont placés que sur un substrat (100), les premières et deuxièmes surfaces de contact (200, 210) de tous les éléments thermoélectriques sont placées en une rangée sur le côté froid (120) du substrat (100) et les troisièmes surfaces de contact (220) de tous les éléments thermoélectriques sont placées en une rangée sur le côté chaud (110 du substrat.

7. Générateur thermoélectrique selon la revendication 5 ou 6, **caractérisé en ce que** la deuxième surface de contact (210) d'un élément thermoélectrique forme en même temps la première surface de contact (200) pour un élément thermoélectrique voisin.

8. Procédé destiné à fabriquer un élément thermoélectrique selon la revendication 1, avec une première couche (300) thermoélectrique et une deuxième couche (330) thermoélectrique, les couches (300, 330) étant conçues en formant une jonction pn (350), la première couche (300) thermoélectrique étant constituée d'une matière thermoélectrique conductrice de type n et la deuxième couche (330) thermoélectrique étant constituée d'une matière thermoélectrique conductrice de type p ou la première couche (300) thermoélectrique étant constituée d'une matière thermoélectrique conductrice de type p et la deuxième couche (330) thermoélectrique étant constituée d'une matière thermoélectrique conductrice de type n, **caractérisé en ce**
- **qu'**on munit un substrat (100) d'au moins une première et au moins une deuxième surfaces de contact (200, 210) sur un côté froid (120) et d'au moins une troisième surface de contact (220) sur un côté chaud (110) du substrat,
- par la suite, on applique la première couche (300) thermoélectrique de l'élément thermoélectrique sur le substrat (100) de telle sorte que la première couche thermoélectrique (300) relie la deuxième surface de contact (210) avec la troisième surface de contact (220) et
- en formant la jonction pn (350), on applique la deuxième couche (330) thermoélectrique de l'élément thermoélectrique sur la première couche (300) thermoélectrique et on la relie avec la première surface de contact (200).

9. Procédé destiné à fabriquer un élément thermoélectrique selon la revendication 8, **caractérisé en ce qu'**on applique les couches thermoélectriques par voie d'un processus d'impression.

10. Procédé destiné à fabriquer un élément thermoélectrique selon la revendication 8 ou 9, **caractérisé en ce qu'**après l'application, on agglomère par frittage et/ou on régénère les couches thermoélectriques.
